# EUROPEAN PATENT APPLICATION

(11) **EP 3 690 959 A1**
(43) Date of publication of application: **05.08.2020**
(21) Application number: 18861525.6
(22) Date of filing: 27.09.2018
(51) Int. Cl.: H01L 31/055

(54) **SOLAR CELL SYSTEM AND SHEET-LIKE STRUCTURE**

(30) Priority: 29.09.2017 JP 2017192256
(71) Applicant: Sekisui Chemical Co., Ltd., Osaka-shi, Osaka 530-8565 (JP)
(72) Inventor: OOTA, Yuusuke, Koka-shi, Shiga 528-8585 (JP); YOSHIDA, Shougo, Koka-shi, Shiga 528-8585 (JP); MATSUDOU, Masaki, Mishima-gun Osaka 618-0021 (JP); II, Daizou, Koka-shi, Shiga 528-8585 (JP); IZU, Yasuyuki, 6045 JB Roermond (NL); NAKAJIMA, Daisuke, Koka-shi, Shiga 528-8585 (JP); CHOU, Kinryou, Koka-shi, Shiga 528-8585 (JP)
(74) Representative: Ter Meer Steinmeister & Partner
(86) International application number: PCT/JP2018/036115
(87) International publication number: WO 2019/065908

(57) **Abstract**

The present invention provides a solar cell system for generating electricity by absorbing sunlight, comprising a sheet-shaped structure comprising a wavelength conversion material and a power generation cell disposed in a peripheral area of the sheet-shaped structure, wherein the wavelength conversion material has an average particle diameter of 10 to 400 nm and a maximum emission wavelength of 500 nm or more. The present invention also provides a sheet-shaped structure used for a solar cell system, comprising a wavelength conversion material having an average particle diameter of 10 to 400 nm and a maximum emission wavelength of 500 nm or more. According to the present invention, a solar cell system that shows high power generation efficiency because of a large amount of light gathered on a power generation cell and shows a high transparency of a member constituting a waveguide for guiding light to the power generation cell, and a sheet-shaped structure for providing such a solar cell system can be provided.

## Description

### Technical Field

The present invention relates to a solar cell system used for solar power generation or other applications on a window and to a sheet-shaped structure used for the solar cell system.

### Background Art

Since it is difficult to secure enough space for installing solar panels in a comparatively high construction such as a building, energy creation is not sufficient. Hence, such an approach that solar cells are mounted on windows has been put to practical uses. Specifically, a system in which a solar cell module is disposed in an intermediate layer of laminated glass, and a system in which a solar cell module is disposed between plates of glass of double glazing are known. However, the transparency of a solar cell module is generally low, and the solar cell module often impairs visibility. Highly transparent organic solar cells are also in practical use, but have the problem that they do not have sufficient durability.

To address the above problems, disposing a solar panel in a peripheral area, such as a window frame, of a window has been studied. For example, a solar radiation conversion device has been developed that contains, in a transparent member such as glass, a wavelength conversion material for converting ultraviolet radiation, visible radiation, or infrared radiation into near infrared radiation and generates electricity by gathering the light that has been converted by the wavelength conversion material onto an end of the transparent member, using the transparent member as a waveguide (for example, see PTL 1).

### Citation List

### Patent Literature

PTL1: WO 2015/047084 A1

### Summary of Invention

### Technical Problem

However, in the solar radiation conversion device disclosed in PTL 1, the transparency of a member constituting the waveguide has been insufficient because a Tm²⁺ based inorganic material that is used as the wavelength conversion material absorbs much light not only in the ultraviolet region and infrared region, but also in the visible radiation region.

The present invention has been made in view of the above circumstances, and an object of the present invention is to provide a solar cell system that shows high power generation efficiency because of a large amount of light gathered on a power generation cell, and shows a high transparency of a member constituting a waveguide for guiding light to the power generation cell, and to provide a sheet-shaped structure for providing such a solar cell system.

### Solution to Problem

The present inventors have carried out earnest investigation to find that the above problems can be solved by a solar cell system including a power generation cell and a sheet-shaped structure containing a wavelength conversion material having a particular average particle diameter and a particular maximum emission wavelength, so that the present invention described below has been completed.

That is, the present invention provides [1] to [10] below.
[1] A solar cell system for generating electricity by absorbing sunlight, comprising a sheet-shaped structure comprising a wavelength conversion material and a power generation cell disposed in a peripheral area of the sheet-shaped structure, wherein the wavelength conversion material has an average particle diameter of 10 to 400 nm and a maximum emission wavelength of 500 nm or more.
[2] The solar cell system according to [1] above, wherein a difference (Tvis - Tuv) between a visible light transmittance Tvis in a range of 380 nm or more and less than 780 nm and a UV transmittance Tuv in a range of 300 nm or more and less than 380 nm of the sheet-shaped structure is 50% or more.
[3] The solar cell system according to [1] or [2] above, wherein the visible light transmittance Tvis of the sheet-shaped structure is 60% or more.
[4] The solar cell system according to any one of [1] to [3] above, wherein the maximum emission wavelength of the wavelength conversion material is 780 nm or more.
[5] The solar cell system according to any one of [1] to [4] above, wherein a maximum excitation wavelength of the wavelength conversion material is 400 nm or less.
[6] The solar cell system according to any one of [1] to [5] above, wherein the average particle diameter of the wavelength conversion material is within 10 to 200 nm.
[7] The solar cell system according to any one of [1] to [6] above, wherein the sheet-shaped structure is a laminated structure comprising:
   a transparent sheet member comprising the wavelength conversion material; and
   first and second transparent sheets disposed on both surfaces, respectively, of the transparent sheet member.
[8] The solar cell system according to [7] above, wherein the transparent sheet member comprises a resin, and the wavelength conversion material is dispersed in the resin.
[9] A sheet-shaped structure used for a solar cell system, comprising a wavelength conversion material, the wavelength conversion material having an average particle diameter of 10 to 400 nm and a maximum emission wavelength of 500 nm or more.
[10] The sheet-shaped structure according to [9] above, wherein a difference (Tvis - Tuv) between a visible light transmittance Tvis in a range of 380 nm or more and less than 780 nm and a UV transmittance Tuv in a range of 300 nm or more and less than 380 nm is 50% or more.

### Advantageous Effects of Invention

The present invention can provide a solar cell system that shows high power generation efficiency because of a large amount of light gathered on a power generation cell and shows a high transparency of a member constituting a waveguide for guiding light to the power generation cell, and a sheet-shaped structure for providing such a solar cell system.

### Brief Description of Drawings

[Fig. 1] Fig. 1 is a schematic cross-sectional view of a sheet-shaped structure according to an embodiment of the present invention.
[Fig. 2] Fig. 2 is a schematic cross-sectional view of a solar cell system according to the embodiment of the present invention.

### Description of Embodiment

A solar cell system of the present invention is a solar cell system generating electricity by absorbing sunlight, which includes a sheet-shaped structure comprising a wavelength conversion material and a power generation cell disposed in a peripheral area of the sheet-shaped structure.

### [Sheet-Shaped Structure]

In the solar cell system of the present invention, the sheet-shaped structure is a member constituting a waveguide for guiding light to the power generation cell. That is, the wavelength conversion material converts at least part of light, such as sunlight, incident on one surface of the sheet-shaped structure into light with comparatively long wavelengths, and the light is then reflected within the sheet-shaped structure and guided to a side surface of the sheet-shaped structure, so that the guided light can be received by the power generation cell. Generally, such light with a long wavelength can be efficiently converted into electricity by a power generation cell. Hence, the power generation efficiency of the power generation cell can be enhanced by causing the power generation cell to receive such light with a long wavelength.

The sheet-shaped structure of the present invention comprises the wavelength conversion material. A difference (Tvis - Tuv) between a visible light transmittance Tvis in a range of 380 nm or more and less than 780 nm and a UV transmittance Tuv in a range of 300 nm or more and less than 380 nm of the sheet-shaped structure is preferably 50% or more. Such a difference means that the wavelength conversion material comprised in the sheet-shaped structure is less apt to absorb visible radiation and more apt to absorb ultraviolet radiation. That is, the sheet-shaped structure constituting the solar cell system of the present invention has a high transparency and an excellent ability to absorb ultraviolet radiation. When the difference Tvis - Tuv is 50% or more, the transparency of the sheet-shaped structure is improved or the amount of light guided to the side surface of the sheet-shaped structure increases, so that the power generation efficiency of the solar cell system is likely to be enhanced.

To improve the transparency of the sheet-shaped structure and to increase the amount of light guided to the side surface, the difference Tvis - Tuv is more preferably 55% or more, further preferably 60% or more, particularly preferably 70% or more.

The visible light transmittance Tvis in the range of 380 nm or more and less than 780 nm means the average transmittance in the range of 380 nm or more and less than 780 nm. The UV transmittance Tuv in the range of 300 nm or more and less than 380 nm means the average transmittance in the range of 300 nm or more and less than 380 nm.

To improve the transparency of the sheet-shaped structure, the transmittance Tvis is preferably 60% or more, more preferably 70% or more, further preferably 80% or more. The transmittance Tvis is preferably as high as possible and may be 100% or less. The transmittance Tvis is practically 99% or less, preferably 95% or less.

To increase the amount of light guided to the side surface of the sheet-shaped structure, the transmittance Tuv is preferably 30% or less, more preferably 20% or less, further preferably 10% or less. The lower limit of the transmittance Tuv is not limited and may be 0% or more, practically 0.001% or more.

### (Wavelength Conversion Material)

In the present invention, the sheet-shaped structure may be a single layer comprising the wavelength conversion material or may be a laminated structure including two or more layers at least one of which comprises the wavelength conversion material. The wavelength conversion material may be dispersed in the layer comprising the wavelength conversion material.

A material that converts light with shorter wavelengths into light with a maximum emission wavelength of 500 nm or more may be used as the wavelength conversion material. The maximum emission wavelength means a wavelength at which the emission intensity determined by measuring an emission spectrum of the wavelength conversion material reaches a maximum.

Specifically, a wavelength conversion material that converts light in the ultraviolet region into light in the near infrared region is preferable. Specific examples of the wavelength conversion material include barium stannate (BaSnO₃), a mixed crystal containing ytterbium and cerium, a mixed crystal containing praseodymium and ytterbium, a mixed crystal containing bismuth and ytterbium, and a wavelength conversion material containing lanthanoid ions such as thulium ions. Among these materials, barium stannate is more preferably used because it absorbs less light in the visible region and can achieve good transparency of a sheet-shaped structure. These wavelength conversion materials may contain impurities and dopants. For example, barium stannate may be doped with ions of a metal such as iron and zinc. YSO (Y₂SiO₅) doped with ytterbium and cerium (YSO:Ce,Yb) or YSO (Y₂SiO₅) doped with praseodymium and ytterbium (YSO:Pr,Yb) is also preferably used as the wavelength conversion material.

The maximum emission wavelength of the wavelength conversion material is 500 nm or more. When the maximum emission wavelength is less than 500 nm, the amount of light guided to the side surface of the sheet-shaped structure is reduced, and the power generation efficiency of the power generation cell is likely to be low.

To increase the amount of light guided to the side surface of the sheet-shaped structure, the maximum emission wavelength of the wavelength conversion material is preferably 780 nm or more, more preferably 800 nm or more, further preferably 820 nm or more. The upper limit of the maximum emission wavelength of the wavelength conversion material is not limited to a particular value, but is preferably 1400 nm or less, more preferably 1300 nm or less, to achieve emission of light by wavelength conversion by a typical wavelength conversion material.

The maximum excitation wavelength of the wavelength conversion material is preferably 400 nm or less, more preferably 390 nm or less, further preferably 380 nm or less, and usually 200 nm or more, preferably 300 nm or more. With such a maximum excitation wavelength, absorption of ultraviolet light and conversion into near infrared light are easily achieved.

In the present invention, the wavelength conversion material may be particulate, and its average particle diameter is 10 to 400 nm. When the average particle diameter is more than 400 nm, the transparency of the sheet-shaped structure is impaired, and the above transmittance Tvis is likely to be reduced. It may be difficult to produce a wavelength conversion material having an average particle diameter of less than 10 nm, and further, in some cases, the emission intensity may be reduced.

To increase the transparency of the sheet-shaped structure, the average particle diameter of the wavelength conversion material is preferably 10 to 200 nm, more preferably 10 to 100 nm. The average particle diameter can be measured with a nanoparticle analyzer (manufactured by HORIBA, Ltd., nanoPartica SZ-100). When the wavelength conversion material has such a particular average particle diameter and the particular maximum emission wavelength above, the transparency of the sheet-shaped structure can be improved, and the amount of light guided to the side surface of the sheet-shaped structure can be effectively increased. The average particle diameter of the wavelength conversion material is measured according to the following procedure. First, the wavelength conversion material is dispersed in methanol so that the concentration will be 5 wt% to provide a measurement sample. The diameter D50 of the measurement sample is measured as the average particle diameter with a nanoparticle analyzer (nanoPartica SZ-100).

The average particle diameter of the wavelength conversion material can be adjusted according to, for example, a method disclosed in Materials 2015, 8, 6437-6454. For example, the average particle diameter of the wavelength conversion material can be adjusted by changing the annealing temperature of the wavelength conversion material.

The sheet-shaped structure of the present invention may be a single layer comprising the wavelength conversion material or may be a laminated structure including two or more layers at least one of which comprises the wavelength conversion material. A laminated structure is preferable. In the sheet-shaped structure of the present invention, at least one layer is preferably a transparent sheet made of inorganic glass or organic glass. In the sheet-shaped structure, one transparent sheet may be used, or two or more transparent sheets may be used. In the present invention, the transparent sheet may emit light, or a layer other than the transparent sheet may emit light.

The sheet-shaped structure preferably includes three or more layers to increase the amount of light guided to the side surface of the sheet-shaped structure, to prevent deterioration of the layer comprising the wavelength conversion material, and to enhance the impact resistance as a window. In particular, the sheet-shaped structure preferably has a laminated structure including the transparent sheet member comprising the wavelength conversion material and the first and second transparent sheets disposed on both surfaces of the transparent sheet member. In this case, the first transparent sheet is disposed on the exterior side, and the second transparent sheet is disposed on the interior side. Sunlight is incident from the first transparent sheet.

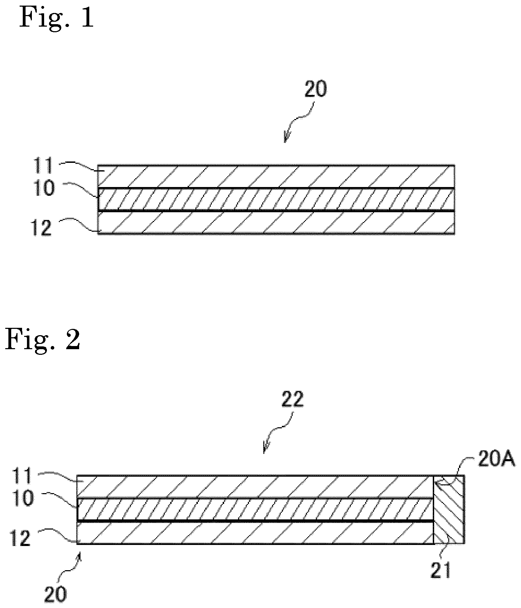

Fig. 1 shows an embodiment in which the sheet-shaped structure is a laminated structure. A laminated structure 20 includes a transparent sheet member 10 and a first transparent sheet 11 and a second transparent sheet 12 respectively disposed on both surfaces of the transparent sheet member 10. Light such as sunlight is incident from the first transparent sheet 11 side. The wavelength conversion material comprised in the transparent sheet member 10 converts part of incident sunlight into light in the near infrared region to contribute to power generation by the power generation cell.

### (Transparent Sheet Member)

The transparent sheet member of the present invention is a layer comprising the wavelength conversion material. The transparent sheet member is preferably a light-emitting layer comprising a resin in which the wavelength conversion material is dispersed. A thermoplastic resin is preferably used as the resin. Employing a thermoplastic resin helps the transparent sheet member to function as an adhesive layer to facilitate adhesion between the transparent sheet member and the first and second transparent sheets.

In the case where the wavelength conversion material is dispersed in the resin, the content of the wavelength conversion material is preferably 0.01 to 3 parts by mass, more preferably 0.02 to 1.5 parts by mass, further preferably 0.03 to 1.0 parts by mass, relative to 100 parts by mass of the resin.

When the content of the wavelength conversion material is equal to or more than the lower limit, the transparent sheet member can sufficiently emit light, the transmittance Tuv described above is reduced, and the difference Tvis - Tuv increases. When the content of the wavelength conversion material is equal to or less than the upper limit, larger decrease in the visible light transmittance Tvis than is necessary can be prevented.

The thermoplastic resin used for the transparent sheet member is not particularly limited. Examples of the resin include polyvinyl acetal resins, ethylene-vinyl acetate copolymer resins, ionomer resins, polyurethane resins, and thermoplastic elastomers. By using these resins, the adhesion to the first transparent sheet and the second transparent sheet is more likely to be ensured. One type of thermoplastic resin may be used singly, or two or more types of thermoplastic resins may be used in combination. Among these resins, a polyvinyl acetal resin is particularly suitable because it shows good adhesion to glass when a plasticizer is comprised in the transparent sheet member.

### «Polyvinyl Acetal Resin»

The polyvinyl acetal resin is not particularly limited, as long as the resin is a polyvinyl acetal resin obtained by acetalizing poly(vinyl alcohol) with an aldehyde, but poly(vinyl butyral) resin is suitable.

As to the degree of acetalization of the polyvinyl acetal resin, the preferred lower limit is 40 mol%, and the preferred upper limit is 85 mol%, and more preferable lower limit is 60 mol%, and more preferable upper limit is 75 mol%.

The lower limit of the hydroxy group content in the polyvinyl acetal resin is preferably 15 mol%, and its upper limit is preferably 35 mol%. When the hydroxy group content is 15 mol% or more, the adhesion to the first transparent sheet and the second transparent sheet, particularly the adhesion in the case where the first transparent sheet and the second transparent sheet are made of inorganic glass, is likely to be improved, and the penetration resistance and the like of the sheet-shaped structure which is a laminated structure is likely to be improved. When the hydroxy group content is 35 mol% or less, the transparent sheet is prevented from being too hard. The lower limit of the hydroxy group content is more preferably 25 mol%, and the upper limit is more preferably 33 mol%.

Also in the case where poly(vinyl butyral) resin is used as the polyvinyl acetal resin, the lower limit of the hydroxy group content is preferably 15 mol%, more preferably 25 mol%, and its upper limit is preferably 35 mol%, more preferably 33 mol%, from similar viewpoints.

The degree of acetalization and the hydroxy group content can be measured by, for example, a method according to JIS K 6728 "Testing methods for poly(vinyl butyral)".

The polyvinyl acetal resin can be prepared by acetalizing poly(vinyl alcohol) with an aldehyde. Poly(vinyl alcohol) is usually obtained by saponifying poly(vinyl acetate), and poly(vinyl alcohol) with a degree of saponification of 80 to 99.8 mol% is commonly used.

The lower limit of the degree of polymerization of the polyvinyl acetal resin is preferably 500, and its upper limit is preferably 4000. When the degree of polymerization is 500 or more, good penetration resistance of the sheet-shaped structure is achieved. When the degree of polymerization is 4000 or less, formation of the sheet-shaped structure is facilitated. The lower limit of the degree of polymerization is more preferably 1000, and the upper limit is more preferably 3600.

The above aldehyde is not particularly limited, but typically, an aldehyde having 1 to 10 carbon atoms is suitably used. The aldehyde having 1 to 10 carbon atoms is not particularly limited, and its examples include n-butyraldehyde, isobutyraldehyde, n-valeraldehyde, 2-ethylbutyraldehyde, n-hexylaldehyde, n-octylaldehyde, n-nonylaldehyde, n-decylaldehyde, formaldehyde, acetaldehyde, and benzaldehyde. Among these, n-butyraldehyde, n-hexylaldehyde, and n-valeraldehyde are preferable, and n-butyraldehyde is more preferable. These aldehydes may be used singly, or in combinations of two or more.

### «Ethylene-Vinyl Acetate Copolymer Resin»

The ethylene-vinyl acetate copolymer resin used for the transparent sheet member may be a non-crosslinkable ethylene-vinyl acetate copolymer resin or a high-temperature-crosslinkable ethylene-vinyl acetate copolymer resin. A modified ethylene-vinyl acetate resin such as a saponified product of ethylene-vinyl acetate copolymer and a hydrolysate of ethylene-vinyl acetate may also be used as the ethylene-vinyl acetate copolymer resin.

The vinyl acetate content in the ethylene-vinyl acetate copolymer resin measured according to JIS K 6730 "Testing methods for ethylene/vinyl acetate copolymer materials" is preferably 10 to 50 mass%, more preferably 20 to 40 mass%. When the vinyl acetate content is equal to or higher than the lower limit, the adhesion between the transparent sheet member and the first and second transparent sheets and the penetration resistance of the sheet-shaped structure are likely to be improved. When the vinyl acetate content is equal to or lower than the upper limit, the breaking strength of the transparent sheet member is enhanced, and the impact resistance of the sheet-shaped structure is improved.

### «Ionomer Resin»

The ionomer resin is not particularly limited, and various ionomer resins can be used. Specific examples include ethylene ionomers, styrene ionomers, perfluorocarbon ionomers, telechelic ionomers, and polyurethane ionomers. Among these ionomers, ethylene ionomers are preferable because the mechanical strength, durability, transparency, and the like of the sheet-shaped structure are improved and because the adhesion to the first transparent sheet and the second transparent sheet in the case where the first transparent sheet and the second transparent sheet are made of glass is improved.

As the ethylene ionomer, an ionomer constituted of an ethylene/unsaturated carboxylic acid copolymer is suitably used because this ionomer shows good transparency and toughness. The ethylene/unsaturated carboxylic acid copolymer is a copolymer having at least a constitutional unit derived from ethylene, a constitutional unit derived from an unsaturated carboxylic acid, and optionally a constitutional unit derived from another monomer.

Examples of the unsaturated carboxylic acid include acrylic acid, methacrylic acid, and maleic acid. Acrylic acid and methacrylic acid are preferable, and methacrylic acid is particularly preferable. Examples of the other monomer include acrylic esters, methacrylic esters, and 1-butene.

The ethylene/unsaturated carboxylic acid copolymer preferably contains 75 to 99 mol% of the constitutional unit derived from ethylene and 1 to 25 mol% of the constitutional unit derived from the unsaturated carboxylic acid, with the total of the constitutional units of the copolymer being 100 mol%.

The ionomer constituted of the ethylene/unsaturated carboxylic acid copolymer is an ionomer resin obtained by neutralizing or crosslinking at least part of carboxy groups contained in the ethylene/unsaturated carboxylic acid copolymer using metal ions, and the degree of neutralization of the carboxy groups is typically 1 to 90%, preferably 5 to 85%.

Examples of the ion source of the ionomer resin include alkali metals such as lithium, sodium, potassium, rubidium, and cesium and polyvalent metals such as magnesium, calcium, and zinc. Sodium and zinc are preferable.

The ionomer resin can be produced by a conventionally known method without particular limitation. For example, in the case where the ionomer constituted of the ethylene/unsaturated carboxylic acid copolymer is used as the ionomer resin, ethylene and the unsaturated carboxylic acid are free-radically copolymerized under high temperature and pressure to produce the ethylene/unsaturated carboxylic acid copolymer. The ethylene/unsaturated carboxylic acid copolymer reacts with a metal compound containing the above ion source, so that the ionomer constituted of the ethylene/unsaturated carboxylic acid copolymer can be produced.

### «Polyurethane Resin»

Examples of the polyurethane resin include polyurethanes obtained from the reaction of an isocyanate compound and a diol compound, and polyurethanes obtained from the reaction of an isocyanate compound, a diol compound, and a chain-lengthening agent such as polyamines. The polyurethane resin may contain sulfur atoms. In such a case, it is preferable that part of or the whole of the above diol be selected from polythiols and sulfur-containing polyols. The polyurethane resin can improve the adhesion to organic glass. Hence, the polyurethane resin is suitably used in the case where at least one of the transparent sheets is made of organic glass.

### <<Thermoplastic Elastomer>>

Examples of the thermoplastic elastomer include styrene-based thermoplastic elastomers and aliphatic polyolefins.

A known styrene-based thermoplastic elastomer can be used as the styrene-based thermoplastic elastomer without particular limitation. The styrene-based thermoplastic elastomer in general contains a styrene monomer polymer block serving as a hard segment and a conjugated diene compound polymer block or its hydrogenated block serving as a soft segment. Specific examples of the styrene-based thermoplastic elastomer include styrene-isoprene diblock copolymers, styrene-butadiene diblock copolymers, styrene-isoprene-styrene triblock copolymers, styrene-butadiene/isoprene-styrene triblock copolymers, styrene-butadiene-styrene triblock copolymers, and their hydrogenated products.

The aliphatic polyolefin may be a saturated aliphatic polyolefin or an unsaturated aliphatic polyolefin. The aliphatic polyolefin may be a polyolefin constituted of a chain olefin as the monomer or a polyolefin constituted of a cyclic olefin as the monomer. To effectively enhance the storage stability and sound-insulating property of an interlayer, the aliphatic polyolefin is preferably a saturated aliphatic polyolefin.

Examples of the material of the aliphatic polyolefin include ethylene, propylene, 1-butene, trans-2-butene, cis-2-butene, 1-pentene, trans-2-pentene, cis-2-pentene, 1-hexene, trans-2-hexene, cis-2-hexene, trans-3-hexene, cis-3-hexene, 1-heptene, trans-2-heptene, cis-2-heptene, trans-3-heptene, cis-3-heptene, 1-octene, trans-2-octene, cis-2-octene, trans-3-octene, cis-3-octene, trans-4-octene, cis-4-octene, 1-nonene, trans-2-nonene, cis-2-nonene, trans-3-nonene, cis-3-nonene, trans-4-nonene, cis-4-nonene, 1-decene, trans-2-decene, cis-2-decene, trans-3-decene, cis-3-decene, trans-4-decene, cis-4-decene, trans-5-decene, cis-5-decene, 4-methyl-1-pentene, and vinylcyclohexane.

### <<Plasticizer>>

In the case where the transparent sheet member contains a thermoplastic resin, a plasticizer may be further contained. The transparent sheet member is made more flexible by the plasticizer contained therein, thereby the sheet-shaped structure which is a laminated structure is also made flexible. In addition, high adhesion to a glass plate can be provided. In the case where a polyvinyl acetal resin is used as the thermoplastic resin, addition of the plasticizer in combination therewith is particularly effective.

Examples of the plasticizer include triethylene glycol di-2-ethylbutyrate, triethylene glycol di-2-ethylhexanoate, triethylene glycol dicaprylate, triethylene glycol di-n-octanoate, triethylene glycol di-n-heptanoate, tetraethylene glycol din-heptanoate, tetraethylene glycol di-2-ethylhexanoate, dibutyl sebacate, dioctyl azelate, dibutyl carbitol adipate, ethylene glycol di-2-ethylbutyrate, 1,3-propylene glycol di-2-ethylbutyrate, 1,4-butylene glycol di-2-ethylbutyrate, 1,2-butylene glycol di-2-ethylbutyrate, diethylene glycol di-2-ethylbutyrate, diethylene glycol di-2-ethylhexanoate, dipropylene glycol di-2-ethylbutyrate, triethylene glycol di-2-ethylpentanoate, tetraethylene glycol di-2-ethylbutyrate, diethylene glycol dicaprylate, triethylene glycol di-n-heptanoate, tetraethylene glycol di-n-heptanoate, triethylene glycol di-2-ethylbutyrate, adipic acid dihexyl, adipic acid dioctyl, adipic acid hexyl cyclohexyl, adipic acid diisononyl, adipic acid heptyl nonyl, sebacic acid dibutyl, oil-modified sebacic acid alkyds, mixtures of phosphoric acid esters and adipic acid esters, adipic acid esters, mixed adipic acid esters prepared from alkyl alcohols each having 4 to 9 carbon atoms and cyclic alcohols each having 4 to 9 carbon atoms, and adipic acid esters each having 6 to 8 carbon atoms, such as adipic acid hexyl. Among the above plasticizers, triethylene glycol di-2-ethylhexanoate (3GO) is particularly suitably used.

The content of the plasticizer is not particularly limited, and its lower limit is preferably 30 parts by mass, and its upper limit is preferably 70 parts by mass, relative to 100 parts by mass of the thermoplastic resin. When the content of the plasticizer is 30 parts by mass or more, the sheet-shaped structure becomes reasonably flexible, and its handleability is improved. When the content of the plasticizer is 70 parts by mass or less, separation of the plasticizer from the transparent sheet member is prevented. The lower limit of the content of the plasticizer is more preferably 35 parts by mass, and the upper limit is more preferably 63 parts by mass.

In the case where the thermoplastic resin is comprised in the transparent sheet member of the present invention, the thermoplastic resin or the combination of the thermoplastic resin and the plasticizer is comprised as the main component therein. The total amount of the thermoplastic resin and the plasticizer is typically 70 mass% or more, preferably 80 mass% or more, further preferably 90 mass% or more, based on the total amount of the transparent sheet member.

### <<Other Additives>>

The transparent sheet member may contain an additive such as an antioxidant, an adhesion control agent, a pigment, and a dye as needed.

The antioxidant is not particularly limited, and examples of the antioxidant include 2,2-bis[[[3-(3,5-di-tert-butyl-4-hydroxyphenyl)propionyl]oxy]methyl]propane-1,3-diol 1,3-bis[3-(3,5-di-tert-butyl-4-hydroxyphenyl)propionate], 4,4'-thiobis(6-tert-butyl-3-methylphenol), 4,4'-dimethyl-6,6'-di(tert-butyl)[2,2'-methylenebis(phenol)], 2,6-di-t-butyl-p-cresol, and 4,4'-butylidenebis-(6-t-butyl-3-methylphenol).

### (First Transparent Sheet and Second Transparent Sheet)

The first transparent sheet and the second transparent sheet may be made of a material which can be used for a window. As a specific example, they may be made of inorganic glass or organic glass. The inorganic glass is not particularly limited, and examples of the inorganic glass include clear glass, float plate glass, polished plate glass, figured glass, net-wired plate glass, line-wired plate glass, and green glass.

The organic glass is not particularly limited, and examples of the organic glass include a transparent resin plate made of a polycarbonate, an acrylic resin, an acrylic copolymer resin, or a polyester.

The first transparent sheet and the second transparent sheet may be made of the same material or different materials. For example, the first transparent sheet may be made of inorganic glass, and the second transparent sheet may be made of organic glass. It is preferable that the first transparent sheet and the second transparent sheet be both made of inorganic glass or both made of organic glass.

The transmittance Tvis of each of the first transparent sheet and second transparent sheet is preferably as high as possible, but is practically 50% or more, preferably 60% or more. The transmittance Tvis of each of the first transparent sheet and second transparent sheet is 100% or less, practically 99% or less. The first transparent sheet and the second transparent sheet may have the same visible light transmittance Tvis or different visible light transmittances Tvis. The thicknesses of the first transparent sheet and the second transparent sheet are each preferably 0.1 to 10 mm, more preferably 0.3 to 7 mm. The thicknesses of the first transparent sheet and the second transparent sheet may be the same or different.

The wavelength conversion material is preferably comprised in the transparent sheet member, but may be comprised in one or both of the first transparent sheet and the second transparent sheet. In such a case, the wavelength conversion material may be dispersed in the first transparent sheet or the second transparent sheet.

In the case where the sheet-shaped structure has the above laminated structure, the production method therefor is not particularly limited. For example, the production may be performed by disposing at least the transparent sheet member between the first transparent sheet and the second transparent sheet, and integrating the sheets by pressure bonding or the like.

In the case where the sheet-shaped structure is the laminated structure, the laminated structure is not limited only to such a layered structure, but may have any other layered structure. For example, another layer than the first transparent sheet, the transparent sheet member, or the second transparent sheet may be included. For example, in the case where the adhesion between the transparent sheet member and the first transparent sheet or the like is low, an adhesive layer may be disposed therebetween. To more efficiently guide light emitted from the wavelength conversion material to the sheet-shaped structure side and to enhance the power generation efficiency, a reflective layer such as a metal film, a heat ray reflecting film, and an infrared radiation reflecting film may be disposed on, for example, one surface of the second transparent sheet.

The sheet-shaped structure may be composed of a single layer as described above. When the sheet-shaped structure is composed of a single layer, the sheet-shaped structure can have a simple structure. In the case where the sheet-shaped structure is composed of a single layer, a member made of inorganic glass or organic glass containing the wavelength conversion material as described above can be used. Further, the wavelength conversion material may be dispersed in inorganic glass, organic glass, or the like.

In the case where the sheet-shaped structure is composed of a single layer, the content of the wavelength conversion material is preferably 0.005 to 2 mass%, more preferably 0.01 to 1 mass%, based on the total amount of the sheet-shaped structure.

The above sheet-shaped structure can be used for the solar cell system described later. Specifically, the solar cell system can be provided by disposing the power generation cell in a peripheral area of the sheet-shaped structure.

### <Solar Cell System>

The solar cell system of the present invention includes the sheet-shaped structure and the power generation cell. The power generation cell is disposed at least at one position in a peripheral area of the sheet-shaped structure. The power generation cell may be disposed such that the power generation cell can receive light guided to the side surface of the sheet-shaped structure by reflection or the like within the sheet-shaped structure.

Fig. 2 shows an example of a solar cell system 22 including the sheet-shaped structure 20 and a power generation cell 21. The power generation cell 21 is typically disposed outside a side surface 20A of the sheet-shaped structure 20. In such a case, the power generation cell 21 may be disposed to be in contact with the side surface 20A of the sheet-shaped structure 20 as shown in Fig. 2 or may be spaced apart from the side surface 20A of the sheet-shaped structure 20 to face the side surface 20A. The power generation cell 21 is not required to be disposed outside the side surface, but may be disposed in a peripheral area of the sheet-shaped structure 20. For example, the power generation cell 21 may be embedded in the sheet-shaped structure 20.

The power generation cell 21 may be disposed such that the power generation cell 21 can receive light propagating through the inside of the sheet-shaped structure 20 over the entire sheet-shaped structure 20 in the thickness direction as shown in Fig. 2, or may be disposed such that it can receive light propagating through the inside of the sheet-shaped structure 20 over a part of the sheet-shaped structure 20 in the thickness direction.

### [Power Generation Cell]

The power generation cell is not particularly limited as long as the cell converts light into electricity. However, a cell that efficiently converts light with the maximum emission wavelength or wavelengths around the maximum emission wavelength into electricity is preferably used as the power generation cell.

Further, the power generation cell has the maximum power generation efficiency preferably at a wavelength of 500 nm or more, more preferably at a wavelength of 780 to 1300 nm. When the power generation efficiency from light in the near infrared region is high as described above, the power generation efficiency can be enhanced in the case when the maximum emission wavelength is in the near infrared region.

Specific examples of the power generation cell include a power generation cell in which a silicon-based semiconductor such as monocrystalline silicon, polycrystalline silicon, and amorphous silicon is used as a photoelectric conversion layer thereof, a power generation cell in which a compound semiconductor typified by CuInSe-based, Cu(In,Ga)Se-based, Ag(In,Ga)Se-based, CuInS-based, Cu(In,Ga)S-based, and Ag(In,Ga)S-based compounds, solid solutions thereof, and CIS-based, CIGS-based, GaAs-based, and CdTe-based is used as a photoelectric conversion layer thereof, and an organic power generation cell in which an organic material such as an organic dye is used for a photoelectric conversion layer thereof.

To enhance the power generation efficiency from light in the near infrared region, a power generation cell in which a silicon semiconductor or a compound semiconductor (CIS or CIGS) is used for a photoelectric conversion layer thereof is preferable.

The solar cell system of the present invention is used such that one surface of the sheet-shaped structure constituting the solar cell system is disposed on the exterior side, from which sunlight is incident, as described above. The solar cell system of the present invention can be used in various fields, preferably for exterior windows of various conveyances such as automobiles, trains, and ships and various buildings such as office buildings, apartment buildings, stand-alone houses, halls, and gymnasiums. In the present specification, the exterior window means a window located at a position on which sunlight is made incident. Hence, the exterior window is typically disposed on the outer surface of a building or a conveyance, but the exterior window of the present specification also includes an inner pane of a double-glazed window as long as the pane is located at a position on which sunlight is made incident.

In an automobile, the solar cell system may be used for a rear window, a side window, or a roof window.

### Examples

The present invention will be described in more detail by referring to examples, but the present invention is by no means limited by these Examples.

Methods for measuring and evaluating the physical properties employed in the present invention are as follows.

### [Maximum Excitation Wavelength and Maximum Emission Wavelength]

The maximum excitation wavelength is a wavelength of excitation light at which the fluorescence intensity that is detected under a condition of the maximum emission wavelength reaches a maximum, when excitation light with wavelengths of 300 to 500 nm is radiated from Fluorolog-3 manufactured by HORIBA, Ltd. The maximum emission wavelength is a wavelength at which the emission intensity that is detected under a condition of 780 to 1400 nm reaches a maximum, when light with the maximum excitation wavelength is radiated.

### [Visible Light Transmittance Tvis]

The visible light transmittance Tvis in the range of 380 nm or more and less than 780 nm of the sheet-shaped structure was measured according to JIS R 3212 with a UV/Vis/IR spectrophotometer (manufactured by Hitachi High-Technologies Corporation, UH4150), and evaluated, based on the following criteria.
A: Equal to or more than 60%
B: Less than 60%

### [UV Transmittance Tuv]

The UV transmittance Tuv in the range of 300 nm or more and less than 380 nm of the sheet-shaped structure was measured according to JIS R 3212 with a UV/Vis/IR spectrophotometer (manufactured by Hitachi High-Technologies Corporation, UH4150).

### [Tvis - Tuv]

The difference (Tvis - Tuv) between the visible light transmittance Tvis and the UV transmittance Tuv measured was determined, and evaluated, based on the following criteria.
A: Equal to or more than 50%
B: Less than 50%

### [Amount of Light at End]

Simulated sunlight was incident in a direction perpendicular to the surface of the sheet-shaped structure (thickness direction) and the amount of light emitted from the side surface of the transparent sheet was measured. The amount (%) of light at an end was obtained from the expression 100 × the amount of light/incident energy. Solar simulator HAL-C100 manufactured by Asahi Spectra Co., Ltd. was used as the source of the simulated sunlight, and the amount of light was measured with a light amount measurement device manufactured by Asahi Spectra Co., Ltd.

The amount (%) of light at an end was evaluated, based on the following criteria.
A: Equal to or more than 1.5%
B: Less than 1.5%

### [Average Particle Diameter of Wavelength Conversion Material]

The average particle diameter of the wavelength conversion material was measured with nanoPartica SZ-100 manufactured by HORIBA, Ltd.

Compounds and materials used for the transparent sheets of respective examples and comparative examples are as follows.
<Poly(vinyl butyral) Resin> The degree of acetalization: 1 mol%, the hydroxy group content: 30.5 mol%, the degree of polymerization: 1700
<Plasticizer> Triethylene glycol di-2-ethylhexanoate (3GO)
<Antioxidant> 2,6-Di-t-butyl-p-cresol (BHT)
<Wavelength Conversion Material> BaSnO₃

The following seven types of BaSnO₃ with different average particle diameters were obtained.
BaSnO₃ (1): the average particle diameter: 50 nm, the maximum excitation wavelength: 370 nm, the maximum emission wavelength: 840 nm
BaSnO₃ (2): the average particle diameter: 100 nm, the maximum excitation wavelength: 370 nm, the maximum emission wavelength: 840 nm
BaSnO₃ (3): the average particle diameter: 10 nm, the maximum excitation wavelength: 370 nm, the maximum emission wavelength: 840 nm
BaSnO₃ (4): the average particle diameter: 400 nm, the maximum excitation wavelength: 370 nm, the maximum emission wavelength: 840 nm
BaSnO₃ (5): the average particle diameter: 2000 nm, the maximum excitation wavelength: 370 nm, the maximum emission wavelength: 840 nm
BaSnO₃ (6): the average particle diameter: 450 nm, the maximum excitation wavelength: 370 nm, the maximum emission wavelength: 840 nm
BaSnO₃ (7): the average particle diameter: 8 nm, the maximum excitation wavelength: 370 nm, the maximum emission wavelength: 840 nm

The average particle diameters were adjusted by changing the sintering temperature and the sintering time. Specifically, the average particle diameter of BaSnO₃ was increased by raising the sintering temperature and/or by extending the sintering time, and the average particle diameter of BaSnO₃ was reduced by lowering the sintering temperature and/or by shortening the sintering time.
<Wavelength Conversion Material> Y₂SiO₅ :Ce, Yb: The average particle diameter: 50 nm, the maximum excitation wavelength: 360 nm, the maximum emission wavelength: 1020 nm
<Wavelength Conversion Material> Y₂SiO₅:Pr, Yb: The average particle diameter: 50 nm, the maximum excitation wavelength: 400 nm, the maximum emission wavelength: 1020 nm
<Wavelength Conversion Material> Diethyl 2,5-dihydroxyterephthalate manufactured by Sigma-Aldrich Co. LLC

The average particle diameter: 50 nm, the maximum excitation wavelength: 390 nm, the emission wavelength: 420 nm
<First Transparent Sheet> Polycarbonate plate (PC plate)
<First Transparent Sheet> Glass plate
<Second Transparent Sheet> Polycarbonate plate (PC plate)
<Second Transparent Sheet> Glass plate

### [Example 1]

### (1) Production of Transparent Sheet Member

To 100 parts by mass of poly(vinyl butyral) resin, 40 parts by mass of the plasticizer, 0.2 parts by mass of the antioxidant, and 0.05 parts by mass of BaSnO₃ (1) as a wavelength conversion material were added and mixed. The mixture was extrusion-molded with a twin-screw anisotropic extruder to produce a transparent sheet member with a thickness of 760 µm.

### (2) Production of Sheet-Shaped Structure (Laminated Structure)

The resulting transparent sheet member was cut into a piece with the size of 300 mm in length and 300 mm in width. The transparent sheet member was inserted between two polycarbonate plates (5 mm in thickness × 300 mm × 300 mm) used as the first transparent sheet and the second transparent sheet, and the product was temporarily bonded together by pressing. The temporarily bonded product was subjected to pressure bonding under a pressure of 1.2 MPa at 150°C in an autoclave for 30 minutes to provide a sheet-shaped structure.

Table 1 shows the evaluation results for the resulting sheet-shaped structure.

### [Examples 2 to 9 and Comparative Examples 1 to 4]

Transparent sheet members were obtained in the same manner as in Example 1, except that the types and amounts of the wavelength conversion materials used were changed as listed in Tables 1 to 3. Subsequently, sheet-shaped structures were obtained in the same manner as in Example 1, except that the first transparent sheets and the second transparent sheets were changed as listed in Tables 1 to 3.

Tables 1 to 3 show the evaluation results for the resulting sheet-shaped structures.

**Table 1**

| | | | | Example 1 | Example 2 | Example 3 | Example 4 | Example 5 |
|---|---|---|---|---|---|---|---|---|
| Sheet-shaped structure | Transparent sheet member | Poly(vinyl butyral) | Parts by mass | 100 | 100 | 100 | 100 | 100 |
| | | Plasticizer | Parts by mass | 40 | 40 | 40 | 40 | 40 |
| | | Antioxidant | Parts by mass | 0.2 | 0.2 | 0.2 | 0.2 | 0.2 |
| | | Wavelength conversion material | Parts by mass | 0.05 | 0.05 | 0.05 | 0.05 | 0.01 |
| | | | Type | BaSnO₃(1) | BaSnO₃(2) | BaSnO₃ (3) | BaSnO₃(4) | BaSnO₃(1) |
| | | | Maximum excitation wavelength (nm) | 370 | 370 | 370 | 370 | 370 |
| | | | Maximum emission wavelength (nm) | 840 | 840 | 840 | 840 | 840 |
| | | | Average particle diameter (nm) | 50 | 100 | 10 | 400 | 50 |
| | First transparent sheet | | Type | PC plate | PC plate | PC plate | PC plate | PC plate |
| | Second transparent sheet | | Type | PC plate | PC plate | PC plate | PC plate | PC plate |
| Evaluation | Visible light transmittance (Tvis) | | % | 80 | 75 | 82 | 62 | 84 |
| | | | Evaluation | A | A | A | A | A |
| | UV transmittance (Tuv) | | % | 5 | 5 | 5 | 5 | 10 |
| | Tvis-Tuv | | % | 75 | 70 | 77 | 57 | 74 |
| | | | Evaluation | A | A | A | A | A |
| | Amount of light at end | | % | 2.4 | 2.68 | 2.0 | 3.0 | 1.6 |
| | | | Evaluation | A | A | A | A | A |

**Table 2**

| | | | | Example 6 | Example 7 | Example 8 | Example 9 |
|---|---|---|---|---|---|---|---|
| Sheet-shaped structure | Transparent sheet member | Poly(vinyl butyral) | Parts by mass | 100 | 100 | 100 | 100 |
| | | Plasticizer | Parts by mass | 40 | 40 | 40 | 40 |
| | | Antioxidant | Parts by mass | 0.2 | 0.2 | 0.2 | 0.2 |
| | | Wavelength conversion material | Parts by mass | 3 | 0.05 | 0.05 | 0.05 |
| | | | Type | BaSnO₃(1) | Y₂SiO₅:Ce,Yb | Y₂SiO₅:Pr,Yb | BaSnO₃(1) |
| | | | Maximum excitation wavelength (nm) | 370 | 360 | 400 | 370 |
| | | | Maximum emission wavelength (nm) | 840 | 1020 | 1020 | 840 |
| | | | Average particle diameter (nm) | 50 | 50 | 50 | 50 |
| | First transparent sheet | | Type | PC plate | PC plate | PC plate | Glass plate |
| | Second transparent sheet | | Type | PC plate | PC plate | PC plate | Glass plate |
| Evaluation | Visible light transmittance (Tvis) | | % | 70 | 80 | 79 | 88 |
| | | | Evaluation | A | A | A | A |
| | UV transmittance (Tuv) | | % | 1 | 4 | 4 | 5 |
| | Tvis-Tuv | | % | 69 | 76 | 75 | 83 |
| | | | Evaluation | A | A | A | A |
| | Amount of light at end | | % | 4.2 | 3.5 | 3.4 | 2.6 |
| | | | Evaluation | A | A | A | A |

**Table 3**

| | | | | Comparative Example 1 | Comparative Example 2 | Comparative Example 3 | Comparative Example 4 |
|---|---|---|---|---|---|---|---|
| Sheet-shaped structure | Transparent sheet member | Poly(vinyl butyral) | Parts by mass | 100 | 100 | 100 | 100 |
| | | Plasticizer | Parts by mass | 40 | 40 | 40 | 40 |
| | | Antioxidant | Parts by mass | 0.2 | 0.2 | 0.2 | 0.2 |
| | | Wavelength conversion material | Parts by mass | 0.05 | 0.05 | 0.05 | 0.05 |
| | | | Type | Diethyl 2,5-dihydroxyterephthalate | BaSnO₃(5) | BaSnO₃ (6) | BaSnO₃ (7) |
| | | | Maximum excitation wavelength (nm) | 390 | 370 | 370 | 370 |
| | | | Maximum emission wavelength (nm) | 420 | 840 | 840 | 840 |
| | | | Average particle diameter (nm) | 50 | 2000 | 450 | 8 |
| | First transparent sheet | | Type | PC plate | PC plate | PC plate | PC plate |
| | Second transparent sheet | | Type | PC plate | PC plate | PC plate | PC plate |
| Evaluation | Visible light transmittance (Tvis) | | % | 85 | 45 | 58 | 85 |
| | | | Evaluation | A | B | B | A |
| | UV transmittance (Tuv) | | % | 5 | 5 | 5 | 5 |
| | Tvis-Tuv | | % | 80 | 40 | 53 | 80 |
| | | | Evaluation | A | B | A | A |
| | Amount of light at end | | % | 1.35 | 1.8 | 1.9 | 1.0 |
| | | | Evaluation | B | A | A | B |

A sheet-shaped structure comprising a wavelength conversion material having a particular average particle diameter and a particular maximum emission wavelength that are specified in the present invention provided a large amount of light at an end when irradiated with simulated sunlight, and showed a high visible light transmittance Tvis and excellent transparency (Examples 1 to 9). On the other hand, in the case where a sheet-shaped structure comprising a wavelength conversion material having an average particle diameter or emission wavelength that are out of the range of the present invention was used, the visible light transmittance Tvis was low, or the amount of light at an end was small (Comparative Examples 1 to 4).

The above results showed that the solar cell system of the present invention, which is constructed at least with a sheet-shaped structure comprising a particular wavelength conversion material and a power generation cell, allowed sunlight incident on the transparent sheet to efficiently reach the power generation cell and showed good power generation efficiency.

### Reference Signs List

10 Transparent sheet member
11 First transparent sheet
12 Second transparent sheet
20 Laminated structure
20A Side surface
21 Power generation cell
22 Solar cell system

## Claims

1. A solar cell system for generating electricity by absorbing sunlight, the solar cell system comprising:
a sheet-shaped structure comprising a wavelength conversion material; and
a power generation cell disposed in a peripheral area of the sheet-shaped structure,
the wavelength conversion material having an average particle diameter of 10 to 400 nm and a maximum emission wavelength of 500 nm or more.

2. The solar cell system according to claim 1, wherein a difference (Tvis - Tuv) between a visible light transmittance Tvis in a range of 380 nm or more and less than 780 nm and a UV transmittance Tuv in a range of 300 nm or more and less than 380 nm of the sheet-shaped structure is 50% or more.

3. The solar cell system according to claim 1 or 2, wherein the visible light transmittance Tvis of the sheet-shaped structure is 60% or more.

4. The solar cell system according to any one of claims 1 to 3, wherein the maximum emission wavelength of the wavelength conversion material is 780 nm or more.

5. The solar cell system according to any one of claims 1 to 4, wherein a maximum excitation wavelength of the wavelength conversion material is 400 nm or less.

6. The solar cell system according to any one of claims 1 to 5, wherein the average particle diameter of the wavelength conversion material is within 10 to 200 nm.

7. The solar cell system according to any one of claims 1 to 6, wherein the sheet-shaped structure is a laminated structure comprising:
a transparent sheet member comprising the wavelength conversion material; and
first and second transparent sheets disposed on both surfaces, respectively, of the transparent sheet member.

8. The solar cell system according to claim 7, wherein the transparent sheet member comprises a resin, and the wavelength conversion material is dispersed in the resin.

9. A sheet-shaped structure used for a solar cell system, the sheet-shaped structure comprising a wavelength conversion material,
the wavelength conversion material having an average particle diameter of 10 to 400 nm and a maximum emission wavelength of 500 nm or more.

10. The sheet-shaped structure according to claim 9, wherein a difference (Tvis - Tuv) between a visible light transmittance Tvis in a range of 380 nm or more and less than 780 nm and a UV transmittance Tuv in a range of 300 nm or more and less than 380 nm is 50% or more.
